# EUROPÄISCHE PATENTSCHRIFT

(11) **EP 0 931 340 B1**
(45) Veröffentlichungstag und Bekanntmachung des Hinweises auf die Patenterteilung: **08.01.2003**
(21) Anmeldenummer: 97941857.1
(22) Anmeldetag: 29.08.1997
(51) Int. Cl.: H01L 21/8246, H01L 27/112

(54) **HALBLEITER-FESTWERTSPEICHER UND VERFAHREN ZU SEINER HERSTELLUNG**
SEMICONDUCTOR READ ONLY MEMORY AND METHOD FOR THE PRODUCTION THEREOF
MEMOIRE MORTE A SEMI-CONDUCTEURS ET SON PROCEDE DE FABRICATION

(30) Priorität: 30.09.1996 DE 19640235
(43) Veröffentlichungstag der Anmeldung: 28.07.1999
(73) Patentinhaber: Infineon Technologies AG, 81669 München (DE)
(72) Erfinder: ZIMMERMANN, Ulrich, D-01099 Dresden (DE)
(74) Vertreter: Fischer, Volker, Dipl.-Ing.
(86) Internationale Anmeldenummer: DE9701897
(87) Internationale Veröffentlichungsnummer: WO98015001

(56) Entgegenhaltungen:
- EP-A- 0 399 191
- WO-A-96/13064
- DE-A- 4 214 923

## Beschreibung

Die Erfindung betrifft einen Halbleiter-Festwertspeicher (ROM) sowie ein Verfahren zu seiner Herstellung, bei denen die Programmierung durch geeignete Manipulation der Speichertransistoren während des Herstellvorgangs erfolgt.

Üblicherweise bestehen derartige ROMs aus einer Vielzahl von parallelen Bitleitungen, welche über die Source- und Drainanschlüsse der Speichertransistoren verlaufen, und mehreren parallelen, senkrecht zu dem Bitleitungen verlaufenden Wortleitungen, welche die Gateanschlüsse jeweils einer Speichertransistorreihe miteinander verbinden. Der Miniaturisierung einer solchen Anordnung sind natürliche Grenzen gesetzt. Das Gate eines jeden Transistors muß eine bestimmte Mindestlänge aufweisen, damit eine sichere Abschnürung des Stromflusses zwischen Source und Drain bei gesperrt geschaltetem Speichertransistor gewährleistet ist. Weiterhin ist der Minimalabstand zwischen Gateelektroden auch durch den Herstellungsvorgang bestimmt.

Zur Erzielung einer erhöhten Packungsdichte wurden schon verschiedene Modifizierungen der üblichen ROMs vorgeschlagen.

WO-A-9 613 064 offenbart eine übliche ROM-struktur.

Aus der DE-42 14 923 A1 sind eine Masken-ROM-Einrichtung in NAND-Struktur und ein Verfahren zu deren Herstellung bekannt, wobei eine Mehrzahl von Gräben, die sich parallel zueinander erstrecken, in einem Speichertransistorgebiet auf der Oberfläche eines Siliziumsubstrates gebildet sind. MOS-Speichertransistoren nutzen dabei die Seitenwände der Gräben als Kanalgebiet. Dazu wird auf die Seitenwände ein dünnes Gateoxid aufgebracht, und auf dieses wird wiederum eine Gateelektrode aufgetragen. Die Bitleitungen verlaufen senkrecht zur Richtung der Gräben abwechselnd auf den Kronen und auf dem Boden. Die Wortleitungen sind im rechten Winkel dazu angeordnet.

Die Programmierung des ROMs erfolgt, indem der Kanal ausgewählter Speichertransistoren durch eine in geeigneter Weise maskierte Implantation dotiert wird. Dadurch kann durch entsprechende Auswahl der Dotierstoffe und deren Konzentration die Einsatzspannung dieser Speichertransistoren auf einen Wert erhöht werden, welcher über der Betriebsspannung liegt. Dotierte Speichertransistoren sperren somit beim Anlegen der Betriebsspannung während des Lesevorganges des ROMs, während nichtdotierte Transistoren beim Anlegen der Betriebsspannung durchschalten.

Ein alternativer Programmiervorgang besteht darin, die Gräben mit einem Isolator zu füllen und an denjenigen Stellen, an denen ein durchschaltender Transistor entstehen soll, an der Grabenseitenwand ein Loch in den Isolator zu ätzen. Daraufhin wird in einem weiteren Herstellungsschritt ein Gateoxid an der Bewandung des Loches gebildet. Auf das Gateoxid wird sodann Polysilizium zur Bildung der Gateelektrode gebracht. Die Bereiche der Grabenseitenwände, in denen kein Gate gebildet wurde, bilden die beim Anlegen der Betriebsspannung sperrenden Zellen.

Die beiden geschilderten Programmierverfahren liefern zwar brauchbare Ergebnisse, dennoch sind ihnen einige spezifische Probleme eigen.

Bei dem aus der DE-42 14 923 A1 bekannten Programmierungsverfahren erfolgt die Implantation der Dotierung und damit die Einstellung der Einsatzspannung mit schrägem Einfallswinkel in bezug auf die Grabenseitenwände, was für die vorliegende Erfindung von Bedeutung ist. Die Maskierung, welche für die selektive Implantation verwendet wird, ist durch eine fototechnische Strukturierung hergestellt und wird nach dem Implantationsvorgang wieder entfernt. Die Lage der Implantation ist also danach nicht mehr erkennbar. Somit ist es ebenfalls nicht mehr möglich, die in den nun folgenden Herstellungsschritten aufzubringenden Gateoxid- und Gateelektrodenschichten direkt an der Lage der Implantationen auszurichten. Demnach besteht die Gefahr einer Dejustage, so daß die Gates nicht genau über den implantierten Bereichen der Kanäle angeordnet sind. Dadurch ist es möglich, daß ein Teil des Kanales eines Speichertransistors, der normalerweise auch beim Anlegen der Betriebsspannung gesperrt sein sollte, eine genügend gute Leitfähigkeit aufweist. Es fließen dann unerwünschte Leckströme, die den Leistungsbedarf des ROMs erhöhen oder sogar die Programmierung verfälschen. Weiterhin ist es nicht ohne weiters möglich, diese Form der Programmierung mit einem durch Shallow-Trench-Isolation (STI) hergestellten Speicher zu integrieren. Die Gräben müssen in einem eigenen Lithographie- und Ätzschritt nach Abschluß des STI-Verfahrens erzeugt werden. Das Gate-Polysilizium läuft dann über Topographie, wodurch Lithographie und Strukturierung der Gateebene erschwert werden.

Auch das zweitgenannte Programmierungsverfahren wirft einige Probleme auf. Die Programmierung erfolgt über eine fototechnisch strukturierte Lackmaske, die diejenigen Stellen offen läßt, an denen ein Loch in den Isolator geätzt werden soll. Auch hier ergeben sich Probleme durch die nicht immer genau einzuhaltende Justage der Programmiermaske. Haben die Gräben die fototechnisch minimal erreichbare Breite F, so führen die Fehljustagen der Programmiermaske in Richtung der Wortleitungen dazu, daß die Überlappung zwischen Graben und Öffnung kleiner als der eigentliche Lochquerschnitt wird und insbesondere deutlich kleiner als F/2 werden kann. Andererseits sind aber an den Stellen, wo in einem Graben 2 Transistoren gegenüberliegen sollen, auch Löcher mit der vollen Grabenbreite (≥ F) zu ätzen. Beim nachfolgenden Ätzprozeß müssen also Löcher geätzt werden, die einen stark unterschiedlichen Querschnitt aufweisen. Da die üblichen Oxid-Ätzprozesse kleine Löcher langsamer öffnen als große, wird in den großen Löchern bereits die untere Bitleitung stark angegriffen, während die kleinen Löcher noch nicht richtig geöffnet sind. Auch die obere Bitleitung wird zwangsläufig überätzt, falls sie nicht durch eine zusätzliche Deckschicht geschützt werden kann. Der Widerstand der angegriffenen Bitleitungen wird deutlich erhöht. Diese technologische Begrenzung führt zu einer Vergrößerung der minimal erreichbaren Zellfläche und damit einem Kostennachteil.

Der Erfindung liegt die **Aufgabe** zugrunde, ein ROM mit vertikalem Transistor zu schaffen, das eine selbstjustierende Programmierung aufweist sowie ein Verfahren zur Herstellung eines solchen ROMs anzugeben.

Die Aufgabe wird durch die Merkmale der Ansprüche 1 und 7 gelöst. Vorteilhafte Ausführungsformen ergeben sich aus den Unteransprüchen.

Die Erfindung verbindet in überraschend vorteilhafter Weise spezielle Merkmale der obigen beiden Programmierungsverfahren.
Indem bei einem ROM mit parallelen Gräben, auf den Grabenböden und den Grabenkronen in Grabenlängsrichtung verlaufenden Bitleitungen, quer dazu verlaufenden Wortleitungen und in den Grabenseitenwänden vertikal verlaufenden Transistoren, die Gräben mit Isolator gefüllt sind, wobei in den Grabenbereichen mit einem Transistor an einer der Grabenseitenwände und mit Transistoren an beiden Grabenseitenwänden der Isolator auf dem gesamten Grabenquerschnitt entfernt ist, erhält man ein selbstjustierend programmiertes ROM. Da der Isolator in den betreffenden Grabenbereichen auf dem gesamten Grabenquerschnitt entfernt ist, ergeben sich keine Schwierigkeiten beim Herstellungsprozeß der isolatorfreien Bereiche in einem Ätzverfahren aufgrund von extremen Abweichungen im Querschnitt der isolatorfreien Bereiche. Die isolatorfreien Bereiche entstehen gleichmäßig beim Ätzen, und ein Anätzen der Bitleitungen ist minimiert.

Vorteilhafterweise sind bei einem erfindungsgemäßen ROM alle Gräben gleich breit und alle isolatorfreien Bereiche in den Gräben gleich groß. Dadurch kann man diese Bereiche sehr genau in einem Ätzverfahren herstellen und mögliche Beschädigungen der Bitleitungen werden weitgehend vermieden.

Gemäß einer vorteilhaften Ausführungsform wird die Leitfähigkeit der Kanalbereiche der durch die Programmieranforderung ausgewählten Transistoren durch eine schräge Dotierimplantation verändert. Die Dotierionen treffen dann von schräg oben auf die zu implantierenden Grabenseitenwände in den vorgesehenen Bereichen auf, während die nicht zur Implantation vorgesehenen Bereiche durch eine Maske abgeschirmt werden.

Gute Ergebnisse werden erzielt, wenn man zur Abschirmung der Grabenseitenwände gegen die Implantation eine Lackmaske verwendet.

Geeigneterweise sind die isolatorfreien Bereiche der Gräben mit einer Gatestruktur gefüllt. Da die Grabenseitenwände dieser Bereiche als die Programmierinformation enthaltende Kanäle genutzt werden, kann man die Transistoren gemäß dieser Ausführungsform in die isolatorfreien Grabenbereiche legen.

In vorteilhafter Weise läßt sich in die durch die erfindungsgemäße Bauart des ROMs mit hoher Genauigkeit gleichmäßig ausgeführten isolatorfreien Bereiche ein Gatestack einbringen.

Gemäß der Erfindung wird zur Herstellung eines ROMS mit parallelen Gräben, auf den Grabenböden und den Grabenkronen in Grabenlängsrichtung verlaufenden Bitleitungen, quer dazu verlaufenden Wortleitungen und in den Grabenseitenwänden der vertikal verlaufenden Transistoren ein Verfahren mit den folgenden Schritten angewandt:
- Die Gräben werden mit Isolator gefüllt;
- An den Stellen, wo später Wort- und Dekoderleitungen über die Gräben laufen werden, werden Löcher, die so breit sind wie der Graben, in den Isolator geätzt;
- Die Kanalbereiche von nach den Programmieranforderungen ausgewählten Transistoren werden mit einem Maskenverfahren in ihrer Leitfähigkeits-Charakteristik verändert;
- Auf die Kanalbereiche werden Gatestrukturen aufgebracht.

Das erfindungsgemäße Herstellungsverfahren gewährleistet eine weitgehende Schonung der Bitleitungen und eine selbstjustierende Programmierung. Die isolatorfreien Bereiche können einfach hergestellt werden, da nicht das Problem auftritt, daß stark voneinander abweichende Querschnitte der in den Isolator zu ätzenden Löcher auftreten. Die isolatorfreien Bereiche werden durch Ätzen somit sehr gleichmäßig gebildet. Dadurch wird vermieden, daß in größeren zu ätzenden Bereichen bereits eine Überätzung auftritt und umliegende Bereiche, wie z.B. die Bitleitungen, angeätzt werden, während kleinere zu ätzende Bereiche noch nicht fertiggeätzt sind. Durch die nach der Herstellung der isolatorfreien Grabenbereiche im Graben übrigbleibenden Isolatorfüllungen, wird der unter diesen Isolatorfüllungen liegende Grabenbereich wirksam gegen eine Beeinflussung durch das nachfolgende Maskenverfahren geschützt. Eine Veränderung der Leitfähigkeits-Charakteristik dieser Grabenseitenwandbereiche wird vermieden.

Die Erfindung wird im folgenden anhand der Zeichnungen detailliert erläutert. Es zeigen:
- Fig. 1: eine perspektivische Ansicht eines Ausschnittes eines erfindungsgemäßen ROMS während des Herstellungsvorganges nach Ätzung der isolator-freien Bereiche in den Gräben und vor Anwendung des Maskenverfahrens;
- Fig. 2: eine Prinzipskizze, welche die schräge Dotier-implantation der Grabenseitenwände darstellt.

Ein Halbleiter-Festwertspeicher (ROM) ist auf einem Siliziumsubstrat 1 aufgebaut. In einer Richtung verlaufen parallel zueinander eine Vielzahl von gradlinigen Gräben 2. Die Gräben 2 haben einen ungefähr rechteckigen Querschnitt. Der Boden 3 kann beispielsweise etwa so breit wie die Höhe der Seitenwände 4 sein. Jedoch sind selbstverständlich auch andere Abmessungen möglich. Wälle 5 zwischen den Gräben 2 weisen ebenfalls einen rechteckigen Querschnitt auf. Dabei ist die Breite der Kronen 6 etwa gleich wie die Breite der Gräben 2. In Grabenrichtung 7 verlaufen die Bitleitungen 8 und 9. Die untere Bitleitung 8 verläuft auf dem Grabenboden 3 und nimmt die gesamte Breite des Grabens 2 ein. Die oberen Bitleitungen 9 verlaufen auf den Kronen 6 und nehmen ebenfalls die gesamte Breite der Kronen 6 ein. Die Bitleitungen 8 und 9 werden beispielsweise durch Diffusion gebildet. Sie können beispielsweise in einer Höhe von etwa einem Viertel der Grabenseitenwandhöhe 4 aufgebracht werden. Es sind aber auch andere geometrische Abmessungen möglich.

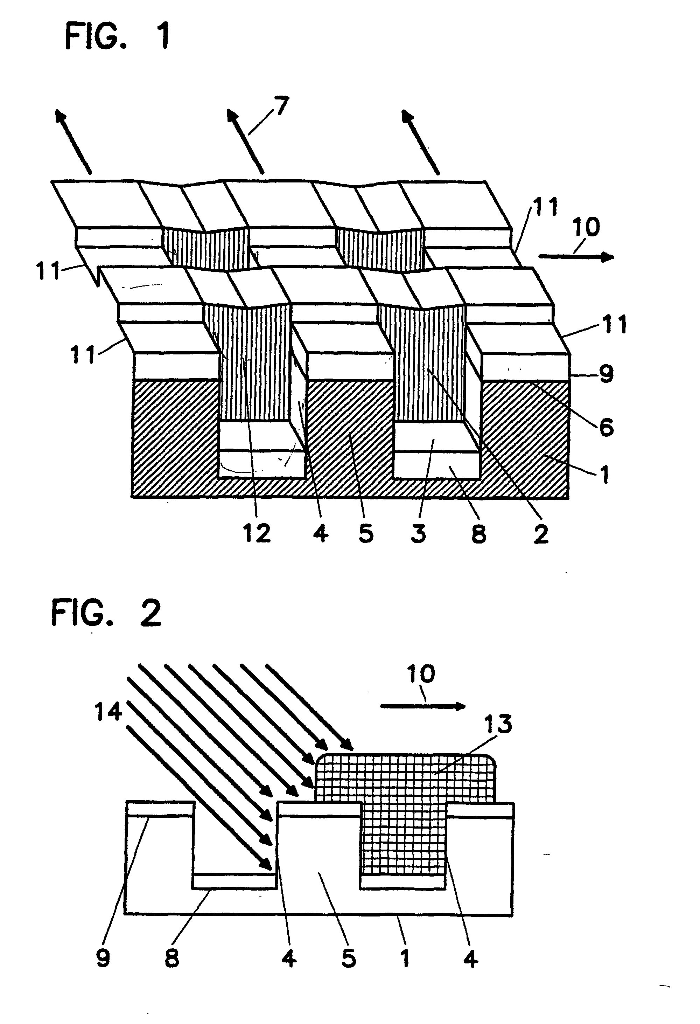

In der Querrichtung 10 verlaufen die in den Figuren nicht dargestellten Wortleitungen. Die Wortleitungen sind beim fertiggestellten ROM oberhalb der oberen Bitleitung 9 angeordnet. Sie queren die Gräben 2 und die Wälle 5 in den Wortleitungsbereichen 11. In den Gräben 2 befindet sich eine Isolatorfüllung 12. In einem vor dem in Fig. 1 dargestellten Herstellungsstadium des ROMS liegenden Herstellungsstadium waren die Gräben 2 vollständig mit der Isolatorfüllung 12 bis an den oberen Rand der oberen Bitleitungen 9 gefüllt. Daraufhin wurden zum Erzielen des in Fig. 1 dargestellten Zustandes des ROMS die Isolatorfüllungen 12 im Überschneidungsbereich der Wortleitungen und der Gräben 2 mit einem Ätzprozeß entfernt. Diese Ätzprozeß liefert quaderförmige Löcher in der Oberfläche des ROMs, die bis auf die unteren Bitleitungen 8 herabreichen und so breit wie die Gräben 2 sind. Diese Löcher werden demnach unten von den unteren Bitleitungen 8, an zwei gegenüberliegenden Seiten von den Grabenseitenwänden 4 und an den beiden anderen gegenüberliegenden Seitenwänden von den Isolatorfüllungen 12 begrenzt.

Der auf den in Fig. 1 dargestellten Herstellungszwischenzustand folgende Herstellungsschritt wird in Fig. 2 dargestellt. Fig. 2 zeigt die Programmierimplantation der ausgewählten Grabenseitenwände 4. Es handelt sich um ein Maskenverfahren, bei dem einzelne Grabenseitenwände 4 durch eine darüber aufgebrachte Lackmaske 13 gegen die Implantation abgeschirmt werden. Die Lackmaske 13 wurde mit einem üblichen fotochemischen Prozeß hergestellt. Von schräg oben erfolgt aus der Implantationsrichtung 14 eine Implantation der Grabenseitenwände 4 mit Dotierionen. Die Dotierionen verändern die Kennlinie eines Transistors, dessen Kanal in der der Implantation ausgesetzten Grabenseitenwand 4 verläuft. Source und Drain des Transistors werden durch die untere Bitleitung 8 und die obere Bitleitung 9 gebildet. Die Gateisolierung wird in Fig. 2 nicht dargestellt. Sie wird in einem auf den Implantationsvorgang folgenden Herstellungsschritt auf der Grabenseitenwand 4 aufgebracht. Dabei wird zunächst ein Gateoxid und dann eine Gateelektrode oder ein Gatestack aufgebracht. Der Transistor verläuft demnach in vertikaler Richtung. Vor dem Herstellen der Gates wurde die Lackmaske 13 wieder entfernt. Es entstehen also in Abhängigkeit davon, ob die den Kanal des betreffenden Transistors bildende Grabenseitenwand 4 der Implantation ausgesetzt war, Transistoren mit unterschiedlichen Kennlinien. Die aufgrund der unterschiedlichen Kennlinien bei einer gegebenen Betriebsspannung möglichen unterschiedlichen Schaltungszustände der Transistoren bilden die Programmierinformationen des ROMs.

Nach der Herstellung der Gates werden diese mit den über den oberen Bitleitungen 9 in Querrichtung 10 verlaufenden Wortleitungen elektrisch verbunden.

## Patentansprüche

1. Halbleiter-Festwertspeicher (ROM) mit parallelen Gräben (2), auf den Grabenböden und den Grabenkronen in Längsrichtung verlaufenden Bitleitungen (8, 9), Wortleitungen und in den Grabenseitenwänden vertikal verlaufenden Transistoren, die jeweils Gates aufweisen, welche mit der Wortleitung verbunden sind, wobei die Gräben (2) vollständig mit einer Isolatorfüllung (12) gefüllt sind, die Isolatorfüllung (12) in den Grabenbereichen mit nur einem Transistor an einer Grabenseitenwand (4) und mit je einem Transistor an beiden gegenüberliegenden Grabenseitenwänden (4) auf dem gesamten Grabenquerschnitt entfernt ist und wobei die Wortleitungen quer zu den Bitleitungen (8, 9) und oberhalb der Bitleitungen (8, 9) verlaufen.

2. Halbleiter-Festwertspeicher nach Anspruch 1,
**dadurch gekennzeichnet,**
**daß** alle Gräben (2) gleich breit sind und alle Isolatorfreien Bereiche in den Gräben (2) gleich groß sind.

3. Halbleiter-Festwertspeicher nach Anspruch 1 oder 2,
**dadurch gekennzeichnet,**
**daß** nach den Programmieranforderungen ausgewählte Kanalbereiche in ihrer Dotierung verändert sind, so daß ihre Leitfähigkeits-Charakteristik verändert ist.

4. Halbleiter-Festwertspeicher nach Anspruch 3,
**dadurch gekennzeichnet,**
**daß** die ausgewählten Kanalbereiche eine zusätzliche Dotierung aufweisen.

5. Halbleiter-Festwertspeicher nach einem der vorhergehenden
**dadurch gekennzeichnet,**
**daß** die isolatorfreien Bereiche mit einer Gatestruktur gefüllt sind.

6. Halbleiter-Festwertspeicher nach Anspruch 5,
**dadurch gekennzeichnet,**
**daß** die Gatestruktur aus Gateoxid und Gatestack besteht.

7. Verfahren zur Herstellung eines Halbleiter-Festwertspeichers nach einem der vorhergehenden Ansprüche, bei dem Kanalbereiche von nach den Programmieranforderungen ausgewählten Transistoren mit einem Maskenverfahren durch Dotierung in ihrer Leitfähigkeit-Charakteristik verändert werden und auf die Kanalbereiche Gatestrukturen aufgebracht werden,
**gekennzeichnet durch** die Schritte:
- die Gräben werden vollständig mit einem Isolator gefüllt;
- an Stellen, wo später die Gatestrukturen und die Kanalbereiche über die Gräben laufen werden, werden Löcher, die so breit wie der Graben sind, in den Isolator geätzt.

8. Verfahren zur Herstellung eines Halbleiter-Festwertspeichers nach Anspruch 7,
**dadurch gekennzeichnet, daß**
die Leitfähigkeit-Charakteristik der Kanalbereiche durch schräge Dotierimplantation verändert wird.

9. Verfahren zur Herstellung eines Halbleiter-Festwertspeichers nach Anspruch 7 oder 8,
**dadurch gekennzeichnet, daß**
das Maskenverfahren mit einer Lackmaske durchgeführt wird.

## Claims

1. Semiconductor read-only memory (ROM) with parallel trenches (2), bit lines (8, 9) running on the trench bases and the trench crowns in the longitudinal direction, word lines and transistors running vertically in the trench side-walls, and which each have gates which are connected to the word line, the trenches (2) being completely filled with an insulator filling (12), the insulator filling (12) in the trench regions having only one transistor on one trench side-wall (4) and with in each case one transistor on both trench side-walls (4) lying opposite being removed over the entire cross-section of the trench and the word lines running transversely to the bit lines (8, 9) and above the bit lines (8, 9).

2. Semiconductor read-only memory according to Claim 1, **characterized in that** all the trenches (2) are of equal width and all the insulator-free regions in the trenches (2) are of equal size.

3. Semiconductor read-only memory according to Claim 1 or 2, **characterized in that** the doping of channel regions which are selected according to the programming requirements is changed, with the result that the conductivity characteristic of said channel regions is changed.

4. Semiconductor read-only memory according to Claim 3, **characterized in that** the selected channel regions have an additional doping.

5. Semiconductor read-only memory according to one of the preceding claims, **characterized in that** the insulator-free regions are filled with a gate structure.

6. Semiconductor read-only memory according to Claim 5, **characterized in that** the gate structure comprises gate oxide and gate stack.

7. Method for manufacturing a semiconductor read-only memory according to one of the preceding claims, in which the conductivity characteristic of channel regions of transistors selected according to the programming requirements is changed with a mask method by means of doping, and gate structures are applied to the channel regions, **characterized by** the steps:
- The trenches are completely filled with an insulator;
- Holes which are as wide as the trench are etched into the insulator at locations where the gate structures and the channel regions will later run over the trenches.

8. Method for manufacturing a semiconductor read-only memory according to Claim 7, **characterized in that** the conductivity characteristic of the channel regions is changed by oblique doping implantation.

9. Method for manufacturing a semiconductor read-only memory according to Claim 7 or 8, **characterized in that** the mask method is carried out with a resist mask.

## Revendications

1. Mémoire morte à semi-conducteurs (ROM) avec des tranchées (2) parallèles, avec des conducteurs de bits (8, 9) s'étendant sur les fonds de tranchées et sur les crêtes de tranchées dans la direction longitudinale, avec des conducteurs de mots et avec des transistors s'étendant verticalement dans les parois latérales de tranchées, lesquels transistors comportent à chaque fois des grilles qui sont reliées au conducteur de mots, les tranchées (2) étant remplies complètement avec un bourrage isolant (12), le bourrage isolant (12) étant enlevé sur toute la section transversale de tranchée dans les zones de tranchées avec seulement un transistor sur une paroi latérale de tranchée (4) et avec à chaque fois un transistor sur les deux parois latérales de tranchée (4) opposées et les conducteurs de mots s'étendant transversalement par rapport aux conducteurs de bits (8, 9) et au-dessus des conducteurs de bits (8, 9).

2. Mémoire morte à semi-conducteurs selon la revendication 1,
**caractérisée par le fait que** toutes les tranchées (2) ont la même largeur et toutes les zones sans isolant dans les tranchées (2) ont la même grandeur.

3. Mémoire morte à semi-conducteurs selon la revendication 1 ou 2,
**caractérisée par le fait que** le dopage de zones de canal sélectionnées selon les instructions de programmation est modifié de telle sorte que leur caractéristique de conductibilité est modifiée.

4. Mémoire morte à semi-conducteurs selon la revendication 3,
**caractérisée par le fait que** les zones de canal sélectionnées ont un dopage supplémentaire.

5. Mémoire morte à semi-conducteurs selon l'une des revendications précédentes,
**caractérisée par le fait que** les zones sans isolant sont remplies avec une structure de grille.

6. Mémoire morte à semi-conducteurs selon la revendication 5,
**caractérisée par le fait que** la structure de grille est constituée d'un oxyde de grille et d'une pile de grille.

7. Procédé de fabrication d'une mémoire morte à semi-conducteurs selon l'une des revendications précédentes, dans lequel on modifie par dopage avec un procédé de masquage la caractéristique de conductibilité des zones de canal de transistors sélectionnés selon les instructions de programmation et on applique des structures de grilles sur les zones de canal,
**caractérisé par** les étapes :
- on remplit complètement les tranchées avec un isolant ;
- aux endroits où les structures de grille et les zones de canal s'étendront plus tard au-dessus des tranchées, on grave dans l'isolant des trous qui sont aussi larges que la tranchée.

8. Procédé pour la fabrication d'une mémoire morte à semi-conducteurs selon la revendication 7,
**caractérisé par le fait qu'**on modifie la caractéristique de conductibilité des zones de canal par une implantation de dopage oblique.

9. Procédé pour la fabrication d'une mémoire morte à semi-conducteurs selon la revendication 7 ou 8,
**caractérisé par le fait qu'**on met en oeuvre le procédé de masquage avec un masque verni.
